# EUROPEAN PATENT APPLICATION

(11) **EP 4 727 312 A1**
(43) Date of publication of application: **15.04.2026**
(21) Application number: 23744035.9
(22) Date of filing: 18.07.2023
(51) Int. Cl.: H10K 59/122

(54) **DISPLAY PANEL AND MANUFACTURING METHOD THEREFOR**

(30) Priority: 12.06.2023 CN 202310687338
(71) Applicant: Shenzhen China Star Optoelectronics Technology Co., Ltd., Shenzhen, Guangdong 518132 (CN)
(72) Inventor: SONG, Zhiwei, Shenzhen, Guangdong 518132 (CN); ZHENG, Shuai, Shenzhen, Guangdong 518132 (CN)
(74) Representative: Herrero & Asociados, S.L.
(86) International application number: PCT/CN2023/107821
(87) International publication number: WO 2024/254935

(57) **Abstract**

The embodiment of the present invention discloses a display panel and a manufacturing method thereof; the display panel includes a substrate, anodes located on the substrate, pixel definition portions disposed at interval and covering edges of the anodes. Each pixel definition portion surrounds one of the anodes. Along a direction parallel the substrate, the pixel definition portion includes a first side surface away from the anode. A first included angle is defined between a side of the first side surface near substrate and the substrate, and the first included angle ranges from 35 degrees to 45 degrees.

## Description

### FIELD OF INVENTION

The present invention relates to a field of displays, especially to a display panel and a manufacturing method thereof.

### BACKGROUND OF INVENTION

With the development of display technology, organic light-emitting diode (OLED) display panels have been widely used due to their advantages such as high brightness, low power consumption, fast response, high clarity, and high luminous efficiency.

However, a technical issue arises in OLED display panels regarding the pixel definition layer, which is formed within the entire layer of the panel and contains apertures that form the light-emitting elements. The presence of stress within the pixel definition layer makes it difficult to release, thus affecting the quality of the display panel.

Therefore, there is an urgent need for a display panel and its manufacturing method to address the aforementioned technical issue.

### SUMMARY OF INVENTION

The present invention provides a display panel and a manufacturing method thereof that effectively mitigate a technical issue concerning release of stress caused by a pixel definition layer's formation within the entire layer of the display panel, thereby safeguarding the overall product quality of the display panel.

To solve the above issue, a technical solution provided by the present application is as follows:

The present invention provides a display panel, comprising:
a substrate;
a plurality of anodes disposed on the substrate; and
a plurality of pixel definition portions covering edges of the anodes and exposing the anodes partially;
wherein each of the pixel definition portions surrounds one of the anodes, and adjacent ones of the pixel definition portions are disposed at intervals;
wherein along a direction parallel to the substrate, the pixel definition portion comprises a first side surface away from the anodes, a first included angle is defined between a side of the first side surface near the substrate and the substrate, the first included angle ranges from 35 degrees to 45 degrees.

Preferably, the display panel further comprises a first metal layer located between the anodes and the substrate; and
the display panel further comprises a first insulation layer located between the first metal layer and the anodes and comprising a first via hole, the anode comprises a first connection portion located in the first via hole and connected to the first metal layer, and the pixel definition portion covers the first connection portion.

Preferably, the display panel further comprises an active layer located between the first metal layer and the substrate and comprising a channel portion and a first conductor sub-portion and a second conductor sub-portion that are located on two opposite sides of the channel portion respectively;
the first metal layer comprises a source electrode and a drain electrode, the source electrode is located on the first conductor sub-portion, the drain electrode is located on the second conductor sub-portion; and
a side of at least a part of the source electrode near the active layer contacts the first conductor sub-portion, and a side of at least a part of the drain electrode near the active layer contacts the second conductor sub-portion.

Preferably, the display panel further comprises a gate electrode located between the source electrode and the drain electrode, and an orthographic projection of the gate electrode on the active layer covers the channel portion; and
the display panel further comprises a gate electrode insulation layer, the gate electrode insulation layer is at least located between the gate electrode and the channel portion.

Preferably, the gate electrode is located on the first metal layer, the gate electrode insulation layer comprises a first insulation portion, a second insulation portion, and a third insulation portion disposed separately from one another, the first insulation portion is disposed between the channel portion and the gate electrode, the second insulation portion is disposed between a part of the source electrode and the first conductor sub-portion, the third insulation portion is disposed between a part of the drain electrode and the second conductor sub-portion; and
an end of the source electrode near the gate electrode contacts the first conductor sub-portion, an end of the drain electrode near the gate electrode contacts the second conductor sub-portion.

Preferably, the gate electrode is located on a side of the first metal layer away from the substrate, no insulation layer is disposed between the source electrode and the first conductor sub-portion, and no insulation layer is disposed between the drain electrode and the second conductor sub-portion.

Preferably, in a plane parallel to the substrate, along a direction from the channel portion to the first conductor sub-portion, an edge of a side of the source electrode away from the gate electrode extends beyond an edge of a side of the first conductor sub-portion away from the channel portion; and
in the plane parallel to the substrate, along a direction from the channel portion to the second conductor sub-portion, an edge of a side of the drain electrode away from the gate electrode extends beyond an edge of a side of the second conductor sub-portion away from the channel portion.

Preferably, the display panel further comprises a second metal layer located between the active layer and the substrate and comprising a first light shielding portion, and an orthographic projection of the active layer on the substrate is located within an orthographic projection of the first light shielding portion on the substrate; and
the display panel further comprises a buffer layer located on a side of the active layer near the substrate and covering the second metal layer.

Preferably, the first insulation layer comprises a passivation layer located near the substrate, the buffer layer is located between the second metal layer and the active layer, a side of the buffer layer away from the substrate directly contacts the active layer and the passivation layer; and
a side of the buffer layer near the substrate directly contacts the second metal layer and the substrate.

Preferably, when the gate electrode insulation layer comprises a first insulation portion, a second insulation portion, and a third insulation portion that are disposed separately from one another, an end of the second insulation portion away from the first insulation portion contacts the buffer layer, and an end of the third insulation portion away from the first insulation portion contacts the buffer layer.

Preferably, the first insulation layer further comprises a second via hole located on a side of the active layer;
the buffer layer comprises a third via hole communicating with the second via hole, the anode is connected to the first light shielding portion through the second via hole and the third via hole; and
the anode comprises a second connection portion, and an orthographic projection of the pixel definition portions on the substrate covers an orthographic projection of the second connection portion on the substrate.

Preferably, a gate electrode insulation layer comprises a fourth via hole located in a side of a second insulation portion away from active layer, the buffer layer comprises a fifth via hole communicating with the fourth via hole, and the source electrode is connected to the first light shielding portion through the fourth via hole and the fifth via hole.

Preferably, a gate electrode insulation layer comprises a sixth via hole located on a side of a third insulation portion away from the active layer, the buffer layer comprises a seventh via hole, the sixth via hole communicates with the seventh via hole, and the drain electrode is connected to the first light shielding portion through the sixth via hole and the seventh via hole.

Preferably, the display panel comprises a display region and a non-display region located on at least one side of the display region, the display panel further comprises a terminal located in the non-display region, and the terminal is located on the first metal layer; and
the terminal comprises a first terminal, and the first terminal is connected to the second metal layer.

Preferably, when a gate electrode insulation layer comprises a first insulation portion, a second insulation portion, and a third insulation portion that are disposed separately from one another, the gate electrode insulation layer further comprises a fourth insulation portion located between the terminal and a buffer layer, the gate electrode insulation layer comprises an eighth via hole defined through the fourth insulation portion, the buffer layer comprises a ninth via hole defined through the buffer layer between the second metal layer wiring and the fourth insulation portion, an orthographic projection of the eighth via hole on the substrate covers an orthographic projection of the ninth via hole on the substrate; and
the first terminal comprises a first terminal connection portion located in the eighth via hole and the ninth via hole, the eighth via hole and the ninth via hole expose the second metal layer wiring, and the first terminal connection portion contacts the second metal layer wiring.

Preferably, the pixel definition portions and the anodes include an overlapping portion, and a width of an orthographic projection of the overlapping portion on the substrate is greater than 2 microns.

Preferably, the display panel further comprises an organic layer located on a side of the anodes away from the substrate and comprising a light emitting layer; and
along the direction parallel to the substrate, the pixel definition portion comprises a second side surface near the anode, an orthographic projection of the anode on the substrate and an orthographic projection of the second side surface on the substrate commonly cover an orthographic projection of the light emitting layer on the substrate.

Preferably, a side of the second side surface near the anode and the anode comprises a second included angle, and the second included angle ranges from 35 degrees to 45 degrees.

The present invention further provides a display panel manufacturing method, comprising:
providing a substrate;
forming an anode material layer on the substrate;
forming a pixel definition material layer on the anode material layer; and
first-patterning the anode material layer and the pixel definition material layer to form a plurality of anodes and a plurality of pixel definition portions, respectively;
wherein the pixel definition portions cover edges of the anodes expose the anodes partially, each of the pixel definition portions surrounds one of the anodes, and adjacent ones of the pixel definition portions are disposed at intervals.

Preferably, before the step of forming the anode material layer on the substrate, the method further comprises:
forming a semiconductor material layer on the substrate;
forming a first metal material layer on the semiconductor material layer, wherein the first metal material layer directly contacts the semiconductor material layer; and
second-processing the semiconductor material layer and the first metal material layer to form a semiconductor layer and a first metal layer respectively;
wherein the first metal layer comprises a source electrode and a drain electrode, wherein the source electrode and the drain electrode are located on two opposite sides of the semiconductor layer.

### ADVANTAGES

The present invention enhances the product quality of the display panel by implementing a configuration where pixel definition portions are individually matched with anodes, with a spacing between adjacent pixel definition portions. This arrangement effectively reduces the stress experienced by the pixel definition portions. Furthermore, the first side surface of the pixel definition portion exhibits a gentler slope, resulting in an increased contact area between the pixel definition portions and an adjacent film layer. This strengthens the bond between the pixel definition portion and the adjacent film layer, thereby improving the overall product quality of the display panel.

### DESCRIPTION OF DRAWINGS

FIG. 1 is a schematic structural view of a first structure of a display panel provided by an embodiment of the present invention;
FIG. 2 is a schematic structural view of a second structure of the display panel provided by the embodiment of the present invention;
FIG. 3 is a flowchart of a display panel manufacturing method provided by the embodiment of the present invention; and
FIGs. 4a to 4m are flowchart schematic views of the display panel manufacturing method of the embodiment of the present invention.

### DETAILED DESCRIPTION OF PREFERRED EMBODIMENTS

The present application provides a display module. To make the objective, the technical solution, and the effect of the present application clearer and more explicit, the present application will be further described in detail below with reference to the accompanying drawings. It should be understood that the specific embodiments described here are only used to explain the present application instead of being used to limit the present application.

At present, after formation of an entire layer of a pixel definition layer in a display panel has a technical issue of difficulty of release of stress of a pixel definition layer resulting in influenced quality of the display panel.

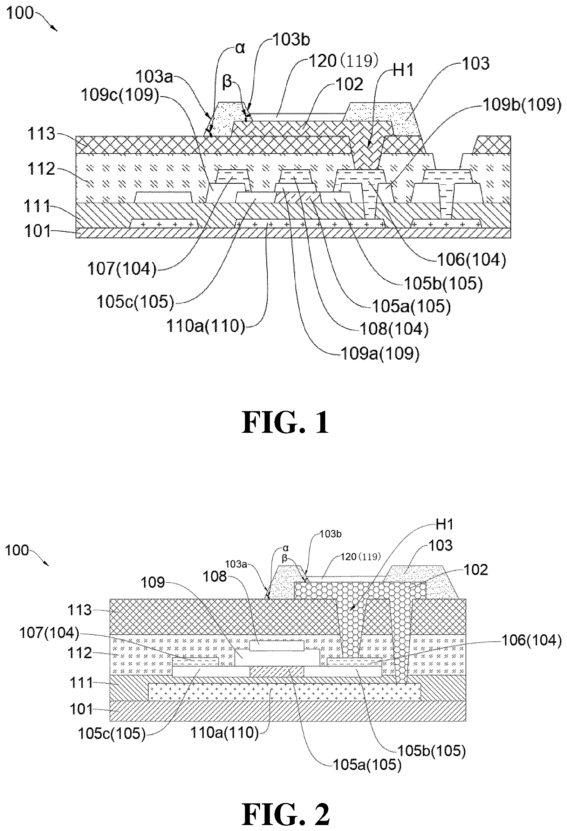

With reference to FIGs. 1 and 2, the embodiment of the present invention provides a display panel 100, comprising:
a substrate 101;
a plurality of anodes 102 located on the substrate 101;
a plurality of pixel definition portions 103 covering edges of the anodes 102 and exposing the anodes 102 partially;
wherein each of the pixel definition portions 103 surrounds one of the anodes 102, and adjacent ones of the pixel definition portions 103 are disposed at intervals;
wherein along a direction parallel to the substrate 101, the pixel definition portion 103 comprises a first side surface 103a away from the anodes 102, a first included angle α is defined between a side of the first side surface 103a near the substrate 101 and the substrate 101, the first included angle α ranges from 35 degrees to 45 degrees.

The embodiment of the present invention correspondingly disposes the pixel definition portions 103 and the anodes 102 one by one with adjacent ones of the pixel definition portions 103 at intervals, which reduces stress applied to the pixel definition portions 103. Furthermore, the first side surface 103a of the pixel definition portion 103 exhibits a gentler slope, which increases a contact area between the pixel definition portion 103 and an adjacent film layer, enhances firmness of the bonding between pixel definition portions 103 and an adjacent film layer, and improves product quality of the display panel 100.

Technical solutions of the present invention are described in combination specific embodiments.

With reference to FIGs. 1 and 2, in the present embodiment, the display panel 100 further comprises a first metal layer 104, and the first metal layer 104 is located between the anode 102 and the substrate 101.

The display panel 100 further comprises a first insulation layer, the first insulation layer is located between the first metal layer 104 and the anode 102. The first insulation layer comprises a first via hole H1. The anode 102 comprises a first connection portion located in the first via hole H1. The first connection portion is connected to the first metal layer 104. The pixel definition portion103 covers the first connection portion.

In some embodiments, the first metal layer 104 can be low resistance material such as Al, Ti, Mo, Cu, Ni, or a plurality of layers or single layer including alloy formed by the above metal, for example, the first metal layer 104 can be a triple lamination structure of molybdenum titanium alloy/copper/molybdenum titanium alloy (MoTi/Cu/MoTi) formed by molybdenum titanium alloy, copper.

When the first metal layer 104 is a triple lamination structure of MoTi/Cu/MoTi formed by a MoTi layer, a Cu layer, and a MoTi layer, a thickness of the MoTi layer near a side of the substrate 101 ranges from 250 Å to 350 Å. A thickness of the Cu layer ranges from 4200 Å to 6500 Å, and a thickness of the MoTi layer away from the substrate 101 ranges from 400 Å to 500 Å.

In some embodiments, the anode 102 comprises material having a high work function. The anode 102 comprises one of indium tin oxide (ITO), indium zinc oxide (IZO), zinc oxide (ZnO), and indium oxide (In₂O₃). The above material is transparent and conductive material including a comparatively high work function. Besides the above listed conductive material, the anode 102 can further comprise reflective material such as silver (Ag), magnesium (Mg), aluminum (Al), platinum (Pt), palladium (Pb), gold (Au), nickel (Ni), neodymium (Nd), iridium (Ir), chromium (Cr), lithium (Li), calcium (Ca), or a combination thereof. The anode 102 can be composed of a single layer or multiple layers of transparent and conductive material and/or reflective conductive material. for example, the anodes 102 can be a triple lamination of IZO/Ag/IZO formed by IZO and Ag. At this time, a thickness of the IZO layer near a side of the substrate 101 can range from 100 Å to 200 Å, a thickness of the Ag layer can range from 1000 Å to 1500 Å, and a thickness of the IZO layer away from a side of the substrate 101 can range from 700 Å to 1000 Å.

With reference to FIGs. 1 and 2, in the present embodiment, the pixel definition portion 103 surrounds the anode 102 and has a pixel definition aperture, and the pixel definition aperture exposes the anodes 102.

In some embodiments, material of the pixel definition portions 103 is selected from organic material such as positive photoresist material or negative photoresist material, for using material of the pixel definition portions 103 as a photoresist. The pixel definition portions 103 and the anodes 102 are formed simultaneously by the same patterning process, which reduces processes and lowers process costs. A thickness of the pixel definition portions 103 can ranges from 2.8 microns to 3.7 microns, for example, it can be 3 microns, 3.2 microns, 3.4 microns, 3.5 microns, 3.6 microns, for forming the pixel definition aperture with a sufficient depth.

In some embodiments, the first insulation layer comprises a passivation layer 112 near a side of the substrate 101 and a planarization layer 113 away from a side of the substrate 101. The passivation layer 112 at least covers the first metal layer 104, the planarization layer 113 to perform a function of providing a flat surface for formation of the anode 102. The anode 102 can directly form a side with the planarization layer 113 away from the substrate 101. Furthermore, the first insulation layer can be formed by the passivation layer 112 and the planarization layer 113.

Material of the passivation layer 112 is selected from inorganic material, for example, nitrogen-silicon compound or oxygen-silicon compound. Material of the planarization layer 113 can be selected from organic material, for example, positive photoresist material or negative photoresist material, for forming the passivation layer 112 and the planarization layer 113 simultaneously by the same patterning process, which reduces processes and lowers process costs.

A thickness of the passivation layer 112 ranges from 3500 Å to 5000 Å, for example, it can be 3600 Å, 3800 Å, 4000 Å, 4200 Å, 4500 Å, 4800 Å, etc., for completely covering the first metal layer 104. A thickness of the planarization layer 113 ranges from 3500 Å to 5000 Å, for example, it can be 3600 Å, 3800 Å, 4000 Å, 4200 Å, 4500 Å, 4800 Å, etc., for providing a flat surface.

The first via hole H1 exposes the first metal layer 104, the anode 102 comprises a first connection portion located in the first via hole H1, and the first connection portion contacts the first metal layer 104 in the first via hole H1 to realize connection of the anode 102 with the first metal layer 104. Because the first connection portion is filled in the first via hole H1 for connecting the first metal layer 104, to prevent an organic layer (for example, a light emitting layer) formed on the anode 102 from falling into the first via hole H1, the pixel definition portion 103 covers the first via hole H1.

When the first insulation layer is composed of the passivation layer 112 and the planarization layer 113, and the first via hole H1 comprises a first sub-via hole located in the passivation layer 112 and a second sub-via hole located in the planarization layer 113.

In some embodiments, the substrate 101 can be a hard substrate or flexible substrate. When the substrate 101 is a hard substrate, the substrate 101 can be a glass substrate. When the substrate 101 is a flexible substrate, material of the substrate 101 can be polyimide.

With reference to FIGs. 1 and 2, in the present embodiment, the first metal layer 104 comprises a source electrode 106 and a drain electrode 107. The first via hole H1 exposes the source electrode 106, and the first connection portion contacts the source electrode 106. Alternatively, the first metal layer 104 exposes the drain electrode 107, and the first connection portion contacts the drain electrode 107.

With reference to FIGs. 1 and 2, in the present embodiment, the display panel 100 further comprises an active layer 105, and the active layer 105 is located between the first metal layer 104 and the substrate 101. The active layer 105 comprises a channel portion 105a and a first conductor sub-portion 105b and a second conductor sub-portion 105c located on two opposite sides of the channel portion 105a respectively.

The source electrode 106 is located on the first conductor sub-portion 105b, and the drain electrode 107 is located on the second conductor sub-portion 105c.

A side of at least a part of the source electrode 106 near the active layer 105 contacts the first conductor sub-portion 105b, a side of at least a part of the drain electrode 107 near the active layer 105 contacts the second conductor sub-portion 105c.

In some embodiments, material of the active layer 105 can be selected from conductive oxide material, for example: indium gallium zinc oxide (IGZO). During formation of the active layer 105, conductorization of the first conductor sub-portion 105b and the second conductor sub-portion 105c can be completed by an ion implantation process or a plasma bombardment process. Utilizing an ion implantation process dopes specific elements or particles including but not limited to H, He, B, Al, N, F, P, Ar, S. Utilizing a plasma bombardment process conductor bombards a material surface of the active layer 105 by energetic particles to form defects (oxygen vacancy), oxygen vacancy can generate carriers to increase conductivity, which achieves conductorization of the first conductor sub-portion 105b and the second conductor sub-portion 105c.

In some embodiments, material of the active layer 105 can be selected from polysilicon.

In the present embodiment, a thickness of the active layer 105 can range from 200 Å to 500 Å, for example, it can be 250 Å, 300 Å, 350 Å, 400 Å, 450 Å, etc..

With reference to FIGs. 1 and 2, in the present embodiment, the display panel 100 further comprises a gate electrode 108. The gate electrode 108 is located on a side of the active layer 105 away from the substrate 101, the gate electrode 108 is located between the source electrode 106 and the drain electrode 107. An orthographic projection of the gate electrode 108 on the active layer 105 covers the channel portion 105a.

In the present embodiment, the display panel 100 further comprises a gate electrode insulation layer 109. The gate electrode insulation layer 109 is located on a side of the gate electrode 108 near the active layer 105, and the gate electrode insulation layer 109 is at least located between the gate electrode 108 and the channel portion 105a. The planarization layer 113 covers the gate electrode insulation layer 109, the first metal layer 104 and/or the gate electrode 108.

In some embodiments, material of the gate electrode 108 can be selected from low resistance material such that Al, Ti, Mo, Cu, Ni, or alloy of the above metal, the gate electrode 108 can be a single layer or multiple layers structure formed by the above metal or alloy.

With reference to FIG. 1, in some embodiments, the gate electrode 108 is located on the first metal layer 104. The source electrode 106, the drain electrode 107, and the gate electrode 108 can be formed in the same process by the same material, which advantages reduces processes and lowers process costs.

In some embodiments, material of the gate electrode insulation layer 109 is selected from at least one of silicon nitride compound and silicon oxide compound. The gate electrode insulation layer 109 can be one or more layers of silicon nitride compound or silicon oxide compound, for example, the gate electrode insulation layer 109 can be a single layer structure formed by silicon oxide.

A thickness of the gate electrode insulation layer 109 ranges from 1000 Å to 2000 Å, for example, it can be 1200 Å, 1500 Å, 1800 Å, etc..

In some embodiments, the gate electrode insulation layer 109 comprises a first insulation portion, a second insulation portion, and a third insulation portion that are disposed separately from one another. The first insulation portion is disposed between the channel portion 105a and the gate electrode 108. The second insulation portion is disposed between a part of the source electrode 106 and the first conductor sub-portion 105b. The third insulation portion is disposed between a part of the drain electrode 107 and the second conductor sub-portion 105c.

The first insulation portion, the second insulation portion, and the third insulation portion are disposed separately from one another. Namely, orthographic projections of the three on the substrate 101 are separated from one another. The first insulation portion and the second insulation portion are separated and, the first insulation portion and the third insulation portion are separated. The gate electrode insulation layer 109 comprises a first aperture located between the first insulation portion and the second insulation portion. The gate electrode insulation layer 109 comprises a second aperture located between the first insulation portion and the third insulation portion.

The first insulation portion is disposed between the channel portion 105a and the gate electrode 108. Namely, along a direction from the substrate 101 to the first metal layer 104, the channel portion 105a and the gate electrode 108 are located on two sides of the first insulation portion respectively. A side of the gate electrode 108 near the first insulation portion directly contacts the first insulation portion, and a side of the first insulation portion near the active layer 105 directly contacts the channel portion 105a. An orthographic projection of the gate electrode 108 on the substrate 101 is located within an orthographic projection of the first insulation portion on the substrate 101. An orthographic projection of the channel portion 105a on the substrate 101 is located within an orthographic projection of the first insulation portion on the substrate 101.

The second insulation portion is disposed between a part of the source electrode 106 and the first conductor sub-portion 105b. A side of the second insulation portion near the substrate 101 directly contacts an end of the first conductor sub-portion 105b away from the channel portion 105a. The second insulation portion at least partially covers the end of the first conductor sub-portion 105b away from the channel portion 105a. An end of the source electrode 106 near the gate electrode 108 contacts the first conductor sub-portion 105b through the first aperture, and the end of the source electrode 106 near the gate electrode 108 covers an end of the second insulation portion near the first insulation portion.

The third insulation portion is disposed between a part of the source electrode 106 and the second conductor sub-portion 105c. A side of the third insulation portion near the substrate 101 directly contacts an end of the second conductor sub-portion 105c away from the channel portion 105a. The third insulation portion at least partially covers the end of the second conductor sub-portion 105c away from the channel portion 105a. An end of the drain electrode 107 near the gate electrode 108 contacts the second conductor sub-portion 105c through the second aperture. An end of the drain electrode 107 near the gate electrode 108 covers an end of the third insulation portion near the first insulation portion.

With reference to FIG. 2, in some embodiments, no insulation layer is disposed between the source electrode 106 and the first conductor sub-portion 105b, and no insulation layer is disposed between the drain electrode 107 and the second conductor sub-portion 105c. Namely, the source electrode 106 is directly located on the first conductor sub-portion 105b, and the drain electrode 107 is directly located on the second conductor sub-portion 105c, which advantages simultaneously forming the first metal layer 104 and the active layer 105 by the same patterning process, which simplifies processes and lowers process costs.

When no insulation layer is formed between the source electrode 106 and the first conductor sub-portion 105b, and no insulation layer is formed between the drain electrode 107 and the second conductor sub-portion 105c, the gate electrode 108 is located on a side of the first metal layer 104 away from the substrate 101, the gate electrode insulation layer 109 is located between the channel portion 105a and the gate electrode 108. An orthographic projection of the gate electrode 108 on the substrate 101 is located within an orthographic projection of the gate electrode insulation layer 109 on the substrate 101. An orthographic projection of the channel portion 105a on the substrate 101 is located within an orthographic projection of the gate electrode insulation layer 109 on the substrate 101. At this time, material of the gate electrode 108 can be a dual layer structure formed by a Cu layer and a MoTi alloy layer, the Cu layer is located on a side of the gate electrode 108 near the substrate 101, the MoTi alloy layer is located on a side of the gate electrode 108 away from the substrate 101. A thickness of the Cu layer ranges from 1800 Å to 4200 Å, for example, it can be 1900 Å, 2500 Å, 3000 Å, 3500 Å, 4000 Å, etc.. A thickness of the MoTi alloy layer ranges from 250 Å to 350 Å, for example, it can be 280 Å, 300 Å, 320 Å, 340 Å, etc..

When no insulation layer is disposed between the source electrode 106 and the first conductor sub-portion 105b, and no insulation layer is disposed between the drain electrode 107 and the second conductor sub-portion 105c, in a plane parallel to the substrate 101, along a direction from the channel portion 105a to the first conductor sub-portion 105b, a side edge of the source electrode 106 away from the gate electrode 108 extends beyond a side edge of the first conductor sub-portion 105b away from the channel portion 105a. In a plane parallel to the substrate 101, along a direction from the channel portion 105a to the second conductor sub-portion 105c, a side edge of the drain electrode 107 away from the gate electrode 108 extends beyond a side edge of the second conductor sub-portion 105c away from the channel portion 105a.

In the present embodiment, the gate electrode 108, the source electrode 106, the drain electrode 107, the active layer 105 cooperatively form a thin film transistor device of the display panel 100.

With reference to FIGs. 1 and 2, in the present embodiment, the display panel 100 further comprises a second metal layer 110, and the second metal layer 110 is located between the active layer 105 and the substrate 101. The second metal layer 110 comprises a first light shielding portion 110a. An orthographic projection of the active layer 105 on the substrate 101 is located within an orthographic projection of the first light shielding portion 110a on the substrate 101. Configuration of the first light shielding portion 110a advantages preventing light emitted out from the substrate 101 from irradiating the active layer 105 and further affecting work performance of the active layer 105.

In some embodiments, material of the second metal layer 110 can be selected from metal material such as Al, Ti, Mo, Cu, Ni, or alloy of the above metal. The second metal layer 110 can be a single layer or multiple layers formed by the above metal material or alloy of the above metal material. For example, the second metal layer 110 can be a dual lamination of MoTi/Cu formed by a MoTi alloy layer and a Cu layer, the MoTi alloy layer is located on a side near the substrate 101, and the Cu layer is located on a side away from the substrate 101. Setting the second metal layer 110 as a structure of MoTi/Cu in combination of light shielding property of MoTi and conductivity of Cu facilitates keeping conductivity of wirings in the second metal layer 110 while implementing light shielding. Preferably, a thickness of the MoTi alloy layer can range from 250 Å to 350 Å, for example, it can be 280 Å, 300 Å, 320 Å, 340 Å, etc.. A thickness of the Cu layer can range from 2800 Å to 8000 Å, for example, it can be 2900 Å, 3000 Å, 3500 Å, 4000 Å, 4500 Å, 5000 Å, 5500 Å, 6000 Å, 6500 Å, 7000 Å, 7500 Å, etc..

The display panel 100 further comprises a buffer layer 111, the buffer layer 111 is located on a side of the active layer 105 near the substrate 101, and the buffer layer 111 covers the second metal layer 110.

The buffer layer 111 is disposed between the second metal layer 110 and the active layer 105, a side of the buffer layer 111 away from the substrate 101 directly contacts the active layer 105, and a side of the buffer layer 111 away from the substrate 101 directly contacts the passivation layer 112.

In some embodiments, a side of the buffer layer 111 near the substrate 101 directly contacts the second metal layer 110, and a side of the buffer layer 111 near the substrate 101 directly contacts the substrate 101.

In some embodiments, material of the buffer layer 111 is selected from at least one of silicon nitride compound and silicon oxide compound. The buffer layer 111 can be a single layer or lamination formed by silicon nitride compound or silicon oxide compound. For example, the buffer layer 111 can comprise a first buffer sub-layer and a second buffer sub-layer. Material of the first buffer sub-layer is silicon nitride compound. Material of the second buffer sub-layer is silicon oxide compound. The first buffer sub-layer is located on a side of the buffer layer 111 near the substrate 101. The second buffer sub-layer is located on a side of the buffer layer 111 away from the substrate 101. A thickness of the first buffer sub-layer ranges from 500 Å to 2000 Å, for example, it can be 800 Å, 1000 Å, 1200 Å, 1500 Å, 1800 Å, etc.. A thickness of the second buffer sub-layer ranges from 2000 Å to 3000 Å, for example, it can be 2200 Å, 2500 Å, 2600 Å, 2800 Å, etc..

When the gate electrode insulation layer 109 comprises the first insulation portion, the second insulation portion, and the third insulation portion disposed separately from one another, an end of the second insulation portion away from the first insulation portion contacts the buffer layer 111, and an end of the third insulation portion away from the first insulation portion contacts the buffer layer 111.

In some embodiments, the first light shielding portion 110a is connected to the source electrode 106; or, the first light shielding portion 110a is connected to the drain electrode 107. Connection of the first light shielding portion 110a with the source electrode 106 or the drain electrode 107 prevents electrical drift of the thin film transistor device caused by the first light shielding portion 110a to improve working performance of the thin film transistor device.

With reference to FIG. 2, when the gate electrode 108 is located on a side of the first metal layer 104 away from the substrate 101, no insulation layer is disposed between the source electrode 106 and the first conductor sub-portion 105b, and no insulation layer is disposed between the drain electrode 107 and the second conductor sub-portion 105c, the source electrode 106 is connected to the first light shielding portion 110a through the anode 102. Alternatively, the drain electrode 107 is connected to the first light shielding portion 110a through the anode 102. At this time, the first insulation layer further comprises a second via hole, the second via hole is located on a side of the active layer 105. The buffer layer 111 comprises a third via hole of the buffer layer 111, the third via hole communicates with the second via hole, the anode 102 is connected to the first light shielding portion 110a through the second via hole and the third via hole. The anode 102 comprises a second connection portion. An orthographic projection of the pixel definition portions 103 on the substrate 101 covers an orthographic projection of the second connection portion on the substrate 101. In particular, the buffer layer 111 comprises a buffer portion covering the first light shielding portion 110a, the second via hole is defined through the first insulation layer, and the third via hole is defined through the buffer portion of the buffer layer 111. An orthographic projection of the second via hole on the substrate 101 covers an orthographic projection of the third via hole on the substrate 101. The second via hole and the third via hole expose the first light shielding portion 110a, and the second connection portion contacts the first light shielding portion 110a. When the anode 102 is connected to the source electrode 106, the source electrode 106 is connected to the first light shielding portion 110a through the anode 102. When the anode 102 is connected to the drain electrode 107, the drain electrode 107 is connected to the first light shielding portion 110a through the anode 102.

When the gate electrode insulation layer 109 comprises the first insulation portion, the second insulation portion, and the third insulation portion that are disposed separately from one another, the gate electrode insulation layer 109 comprises a fourth via hole, and the fourth via hole is located on a saide of the second insulation portion away from active layer 105. The buffer layer 111 comprises a fifth via hole, the fifth via hole is located on the buffer layer 111, and the fourth via hole communicates with the fifth via hole. The source electrode 106 is connected to the first light shielding portion 110a through the fourth via hole and the fifth via hole. In particular, the buffer layer 111 comprises a buffer portion covering the first light shielding portion 110a, the fourth via hole is defined through a side of the second insulation portion away from the active layer 105, and the fifth via hole is defined through the buffer portion. An orthographic projection of the fourth via hole on the substrate 101 covers an orthographic projection of the fifth via hole on the substrate 101. The source electrode 106 comprises a source electrode 106 connection portion, and the source electrode 106 connection portion is located in the fourth via hole and the fifth via hole. The fourth via hole and the fifth via hole expose the first light shielding portion 110a, the source electrode 106 connection portion contacts the first light shielding portion 110a to achieve connection of the source electrode 106 with the first light shielding portion 110a.

Alternatively, with reference to FIG. 1, when the gate electrode insulation layer 109 comprises the first insulation portion, the second insulation portion and the third insulation portion disposed separately from one another, the gate electrode insulation layer 109 comprises a sixth via hole, and the sixth via hole is defined through a side of the third insulation portion away from the active layer 105. The buffer layer 111 comprises a seventh via hole, the seventh via hole is defined through the buffer layer 111, and the sixth via hole communicates with the seventh via hole. The drain electrode 107 is connected to the first light shielding portion 110a through the sixth via hole and the seventh via hole. In particular, the sixth via hole is defined through a side of the third insulation portion away from the active layer 105, the seventh via hole is defined through the buffer portion, and an orthographic projection of the sixth via hole on the substrate 101 covers an orthographic projection of the seventh via hole on the substrate 101. The drain electrode 107 comprises a drain electrode 107 connection portion, the drain electrode 107 connection portion is located in the sixth via hole and the seventh via hole, and the sixth via hole and the seventh via hole exposes the first light shielding portion 110a. The drain electrode 107 connection portion contacts the first light shielding portion 110a to achieve connection of the drain electrode 107 with the first light shielding portion 110a.

In the present embodiment, the display panel 100 comprises a display region and a non-display region located on at least one side of the display region. The display panel 100 further comprises a terminal in the non-display region, the terminals is located in the first metal layer 104.

The non-display region comprises a plurality of terminals, the terminals comprise a first terminal, and the first terminal is connected to the second metal layer 110. The second metal layer 110 further comprises a second metal layer wiring, and the first terminal is connected to the second metal layer wiring.

When the gate electrode insulation layer 109 comprises the first insulation portion, the second insulation portion, and the third insulation portion disposed separately from one another, the gate electrode insulation layer 109 further comprises a fourth insulation portion located between the terminal and the buffer layer 111, the gate electrode insulation layer 109 further comprises a eighth via hole, and the eighth via hole is defined through the fourth insulation portion. The buffer layer 111 comprises a ninth via hole, the ninth via hole is defined through the buffer layer 111 between the second metal layer wiring and the fourth insulation portion. An orthographic projection of the eighth via hole on the substrate 101 covers an orthographic projection of the ninth via hole on the substrate 101. The first terminal comprises a first terminal connection portion, and the first terminal connection portion is located in the eighth via hole and the ninth via hole. The eighth via hole and the ninth via hole expose the second metal layer wiring, and the first terminal connection portion contacts the second metal layer wiring.

When the gate electrode 108 is located on a side of the first metal layer 104 away from the substrate 101, no insulation layer is disposed between the source electrode 106 and the first conductor sub-portion 105b, and no insulation layer is disposed between the drain electrode 107 and the second conductor sub-portion 105c. The buffer layer 111 comprises a tenth via hole, and the tenth via hole is defined through the buffer layer 111 between the second metal layer wiring and the first terminal. The first terminal comprises a first terminal connection portion, the first terminal connection portion is located in the tenth via hole, the tenth via hole exposes the second metal layer wiring, and the first terminal connection portion contacts the second metal layer wiring.

In some embodiments, the pixel definition portion 103 and the anode 102 have an overlapping portion, a width of an orthographic projection of the overlapping portion on the substrate 101 is greater than 2 microns to prevent exposure of edges of the anodes 102 due to process errors, and is for covering the first connection portion and/or the second connection portion. The anode 102 comprises a central portion not covered by the pixel definition portions 103 and a periphery portion covered by the pixel definition portions 103. An orthographic projection of the periphery portion on the substrate 101 coincides with an orthographic projection of the overlapping portion on the substrate 101. The overlapping portion comprises a first side near the central portion and a second side away from the central portion. A width of an orthographic projection of the overlapping portion on the substrate 101 is greater than 2 microns, namely, a minimum distance between the first side and the second side is greater than 2 microns.

In some embodiments, an interval between adjacent ones of the anodes 102 is greater than 7 microns to guarantee that under a circumstance of a sufficient resolution, the intervals among the pixel definition portions 103 have a sufficient distance to facilitate easing stress applied to the pixel definition portions 103 and improving a light emission rate of the display panel 100.

With reference to FIGs. 1 and 2, in the present embodiment, the planarization layer 113 is parallel to the substrate 101. The pixel definition portion 103 directly contacts the planarization layer 113, and the first included angle α is equal to an included angle defined between the first side surface 103a and the planarization layer 113. The first included angle α ranges from 35 degrees to 45 degrees, for example, the first included angle α can be 36 degrees, 37 degrees, 38 degrees, 39 degrees, 40 degrees, 41 degrees, 42 degrees, 43 degrees, 44 degrees, etc.. An angle value of the first included angle α is within the above range such that a slope the first side surface 103a is gentler. Also, under a circumstance of a constant height, a total surface area of the pixel definition portions 103 increases, which facilitates increasing a contact area between the pixel definition portions 103 and an adjacent film layer, enhances firmness of the bonding between the pixel definition portions 103 and an adjacent film layer such that the display panel 100 applied to a bending scenario would not easily have separated film layers, and improves product quality of the display panel 100.

With reference to FIGs. 1 and 2, in the present embodiment, the display panel 100 further comprises an organic layer 119 located on a side of the anodes 102 away from the substrate 101. The organic layer 119 comprises a light emitting layer 120. Along a direction parallel to the substrate 101, the pixel definition portion 103 comprises a second side surface 103b near the anode 102. An orthographic projection of the anode 102 on the substrate 101 and an orthographic projection of the second side surface 103b on the substrate 101 commonly cover an orthographic projection of the light emitting layer 120 on the substrate 101. Namely, the light emitting layer 120 is located in the pixel definition aperture, an edge of the light emitting layer 120 does not extend beyond the second side surface 103b. The orthographic projection of the anode 102 on the substrate 101 and the orthographic projection of the second side surface 103b on the substrate 101 commonly cover the orthographic projection of the light emitting layer 120 on the substrate 101, which advantages to prevent light emitting layer of different light emission colors (for example: red, green, blue) from being mixed outside the pixel definition portions 103 and influencing display quality of the display panel 100.

With reference to FIGs. 1 and 2, in some embodiments, a second included angle β is defined between a side of the second side surface 103b near the anode 102 and the anode 102. The second included angle β ranges from 35 degrees to 45 degrees. For example, the second included angle β can be 36 degrees, 37 degrees, 38 degrees, 39 degrees, 40 degrees, 41 degrees, 42 degrees, 43 degrees, 44 degrees, etc.. When the second included angle β is within the above range, the second side surface 103b is more gentle and facilitates formation of the light emitting layer 120 without extending beyond the second side surface 103b.

In the present embodiment, the organic layer 119 comprises a hole injection layer, a hole transport layer, an electron transport layer, and an electron injection layer located in the pixel definition aperture. The hole injection layer is located on a side of the anodes 102 away from the substrate 101. The hole injection layer, the hole transport layer, the light emitting layer, the electron transport layer and the electron injection layer are sequentially laminated.

In the present embodiment, the display panel 100 further comprises a cathode, and the cathode at least covers a side of the organic layer away from the substrate 101.

The anodes 102, the cathode, and the organic layer cooperatively to form a light emitting element.

The embodiment of the present invention correspondingly disposes the pixel definition portions 103 and the anodes 102 one by one with adjacent ones of the pixel definition portions 103 at intervals, which reduces stress applied to the pixel definition portions 103. The first side surface 103a of pixel definition portions 103 exhibits a gentler slope, which increases a contact area between the pixel definition portions 103 and an adjacent film layer, enhances firmness of the bonding between the pixel definition portions 103 and an adjacent film layer, and improves product quality of the display panel 100.

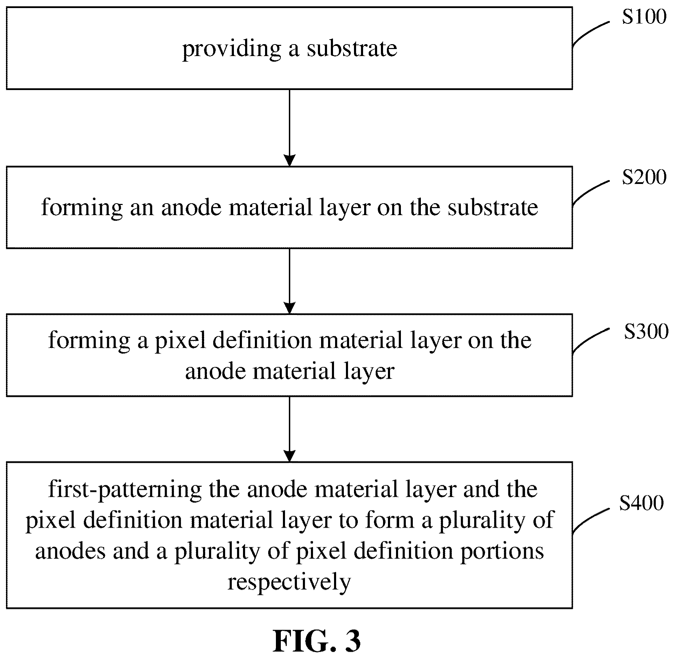

With reference to FIGs. 1 to 3, and FIGs. 4a to 4m, the embodiment of the present invention also provides a method for manufacturing the display panel 100, comprising steps as follows:
A step S100 comprises providing a substrate 101.
A step S200 comprises forming an anode material layer on the substrate 101.
A step S300 comprises forming a pixel definition material layer on the anode material layer.
A step S400 comprises first-patterning the anode material layer and the pixel definition material layer to form a plurality of anodes 102 and a plurality of pixel definition portions 103 respectively.

The pixel definition portions 103 cover edges of the anodes 102 and expose the anodes 102 partially, each of the pixel definition portions 103 surrounds one of the anodes 102, and adjacent ones of the pixel definition portions 103 are disposed at intervals.

Along a direction parallel to the substrate 101, the pixel definition portion 103 comprises a first side surface 103a away from the anodes 102. A first included angle α is defined between a side of the first side surface 103a near the substrate 101 and the substrate 101. The first included angle α ranges from 35 degrees to 45 degrees.

In the present embodiment, material of the substrate 101 has been described detailedly in the above display panel 100, and no repeated description is here.

In the present embodiment, the anode material layer comprises material with a high work function. The anode material layer comprises one of indium tin oxide (ITO), indium zinc oxide (IZO), zinc oxide (ZnO), and indium oxide (In₂O₃). The above material is transparent and conductive material including a comparatively high work function. Besides the above listed conductive material, the anode material layer can also comprise reflective material such as silver (Ag), magnesium (Mg), aluminum (Al), platinum (Pt), palladium (Pb), gold (Au), nickel (Ni), neodymium (Nd), iridium (Ir), chromium (Cr), lithium (Li), calcium (Ca) or a combination thereof. The anode material layer can be a single layer or multiple layers of transparent and conductive material and/or reflective conductive material. For example, the anode material layer can be a triple lamination of IZO material layer/Ag material layer/IZO material layer formed by a IZO material layer and a Ag material layer. The anode material layer can be formed by a physical vapor deposition process or a chemical vapor deposition process.

In the present embodiment, material of the pixel definition material layer is selected from organic material, for example, positive photoresist material or negative photoresist material to facilitate utilizing the pixel definition material layer as a photoresist, the pixel definition portions 103 and the anodes 102 are formed simultaneously by the same patterning process, which reduces processes and lower process costs.

In some embodiments, the step S400 comprises steps as follows:
A step S410 comprises by a first mask exposing the pixel definition material layer.

The first mask can be a half-tone mask.

A step S420 comprises developing the pixel definition material layer to form a first photoresist region, a second photoresist region, and a first non-photoresist region.

A thickness of the pixel definition material layer in the first photoresist region is greater than a thickness of the pixel definition material layer in the second photoresist region.

A step S430 comprises by a first etching process removing the anode material layer corresponding to the first non-photoresist region to form the anodes 102.

The first etching process can be a wet-etching process, when the anode material layer is a triple lamination of IZO material layer/Ag material layer/IZO material layer formed by IZO material layer and Ag material layer, the first etching process utilizes a first etchant, and the first etchant comprises phosphoric acid, nitric acid, etc., for etching Ag material layer and IZO material layer.

A step S440 comprises removing the pixel definition material layer in the second photoresist region, retaining the pixel definition material layer in the first photoresist region to form the pixel definition portions 103.

The pixel definition material layer in the second photoresist region can be removed by an ashing process.

In some embodiments, the step S400 further comprises steps as follows:
A step S450 comprises cleaning the pixel definition portions 103 and the anodes 102.
A step S460 heating the pixel definition portions 103.

Material, thicknesses, and structures of the anodes 102 and the pixel definition portions 103 have been described detailedly in the aforementioned display panel 100, and no repeated description is here.

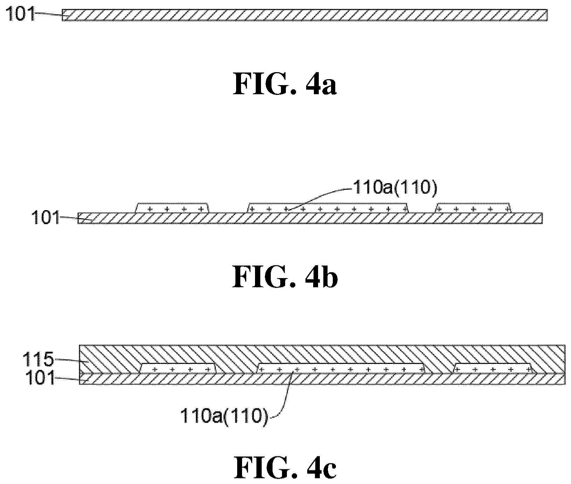

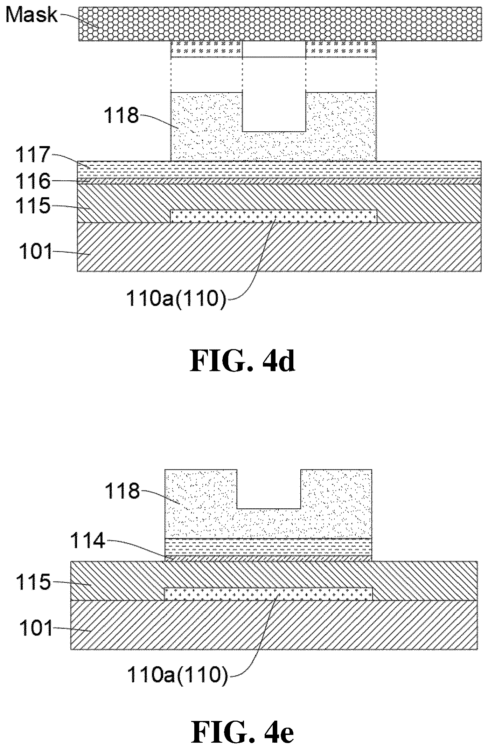

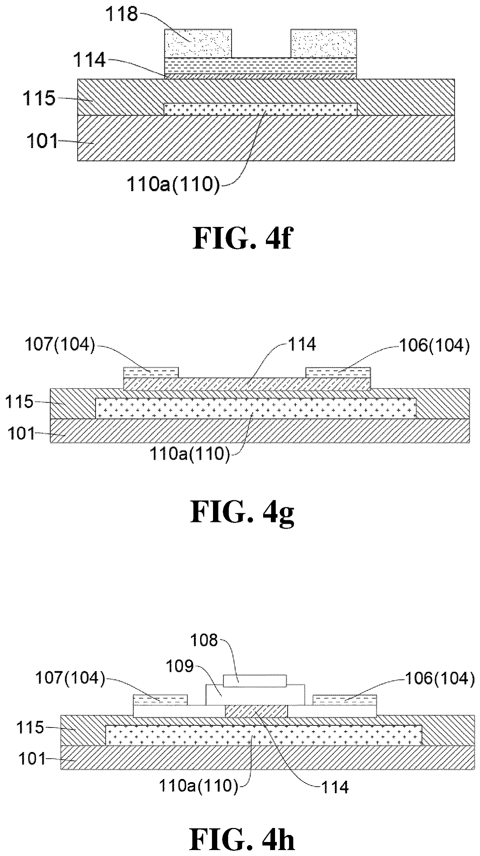

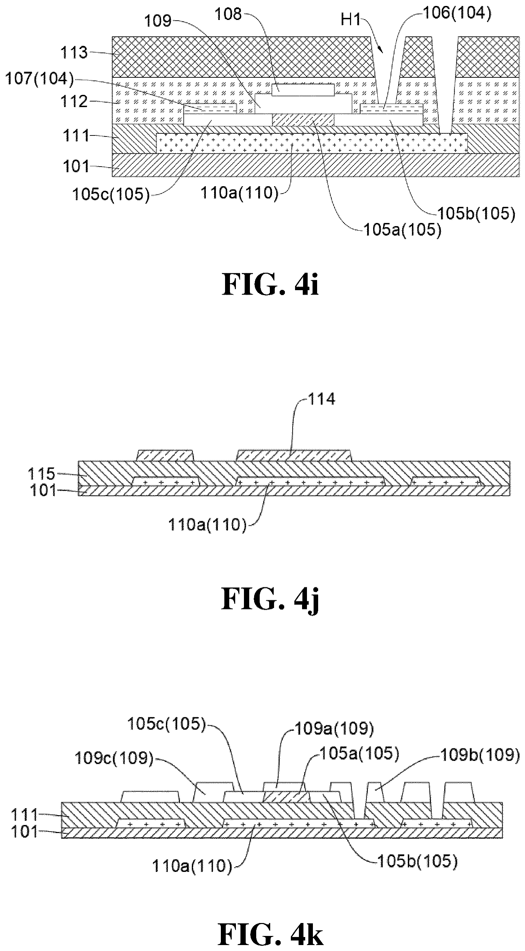

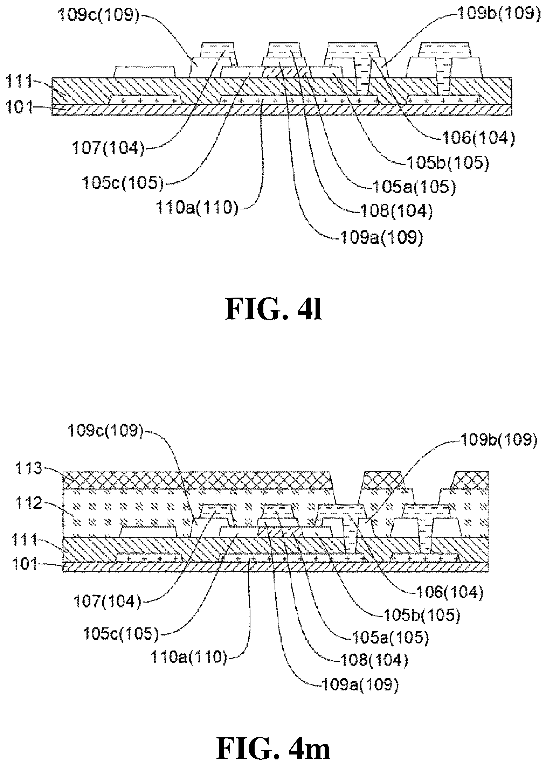

In the present embodiment, before the step S200, the method comprises steps as follows:
With reference to FIG. 4b, a step S500 comprises forming a second metal layer 110 on the substrate 101.

In the present embodiment, material, thickness, and structure of the second metal layer 110 have been described detailedly in the aforementioned display panel 100, and no repeated description is here.

With reference to FIG. 4c, a step S600 comprises forming a buffer material layer 115 on the second metal layer 110.

The buffer material layer 115 covers the second metal layer 110 and the substrate 101.

A step S700 comprises forming a thin film transistor layer on the buffer material layer 115.

A step S800 comprises forming a passivation layer 112 and a planarization layer 113 on the thin film transistor layer.

In the present embodiment, material, thicknesses, and structures of the passivation layer 112 and planarization layer 113 have been described detailedly in the aforementioned display panel 100, and no repeated description is here.

The passivation material layer covers the thin film transistor layer, the planarization material layer covers the passivation material layer. Material of the planarization material layer is positive photoresist material or negative photoresist material.

With reference to FIGs. 4d to 4h, in some embodiments, the step S700 comprises:
a step S710 comprising forming a semiconductor layer 114 and a first metal layer 104 on the buffer layer 111.

The step S710 comprises steps as follows steps as follows:
A step S711 comprises forming a semiconductor material layer 116 on the substrate 101.
A step S712 comprises forming a first metal material layer 117 on the semiconductor material layer 116, wherein the first metal material layer 117 directly contacts the semiconductor material layer 116.
A step S713 comprises second-processing the semiconductor material layer 116 and the first metal material layer 117 to form a semiconductor layer 114 and a first metal layer 104 respectively.

The first metal layer 104 comprises a source electrode 106 and a drain electrode 107, and the source electrode 106 and the drain electrode 107 are located respectively on two opposite sides of the semiconductor layer 114.

No insulation layer is formed between the source electrode 106 and the first conductor sub-portion 105b, and no insulation layer is formed between the drain electrode 107 and the second conductor sub-portion 105c.

The step S713 comprises steps as follows:
A step S713a comprises forming a first photoresist material layer 118 on the first metal material layer.
A step S713b comprises by a second mask Mask, exposing the first photoresist material layer 118.

The second mask Mask can be a half-tone mask.

A step S713c comprises developing the first photoresist material layer 118 to form a third photoresist region, a fourth photoresist region, and a second non-photoresist region.

A thickness of the first photoresist material layer 118 in the third photoresist region is greater than a thickness of the first photoresist material layer 118 in the fourth photoresist region.

A step S713d comprises by a second etching process removing the semiconductor material layer 116 and the first metal material layer 117 corresponding to the second non-photoresist region to form the semiconductor layer 114.

The second etching process can be a wet-etching process.

A step S713e comprises by an ashing process removing the first photoresist material layer 118 in the fourth photoresist region.

A step S713f comprises by a third etching process removing the first metal material layer 117 corresponding to the fourth photoresist region to form the first metal layer 104.

When the third etching process can be a wet-etching process and the first metal material layer is a MoTi/Cu/MoTi triple lamination structure formed by a MoTi layer, a Cu layer, and a MoTi layer, the third etching process utilizes a second etchant, the second etchant is free of fluorine to prevent damages to the semiconductor layer 114. The second etchant includes hydrogen peroxide for the first metal material layer.

A step S713g comprises removing the first photoresist material layer 118.

A step S720 comprises forming a gate electrode insulation layer 109 and a gate electrode 108 between the source electrode 106 and the drain electrode 107.

The step S720 comprises steps as follows:
A step S721 comprises forming a gate electrode insulative material layer on the first metal layer 104.
A step S722 comprises forming a gate electrode material layer on the gate electrode insulative material layer.
A step S723 comprises third-patterning the gate electrode insulative material layer and the gate electrode material layer to form the gate electrode insulation layer 109 and the gate electrode 108.

The step S723 comprises steps as follows:
A S723a comprises forming a second photoresist material layer on the gate electrode material layer.
A step S723b comprises by a third mask exposing the second photoresist material layer.
A step S723c comprises developing the second photoresist material layer to form a fifth photoresist region and a third non-photoresist region.
A step S723d comprises by a fourth etching process removing the gate electrode material layer corresponding to the third non-photoresist region to form the gate electrode 108.

The fourth etching process can be a wet-etching process.

A step S723e comprises by a fifth etching process removing the gate electrode insulative material layer corresponding to the third non-photoresist region to form the gate electrode insulation layer 109.

The fifth etching process can be a dry-etching process.

A step S723f comprises removing the second photoresist material layer.

A step S730 comprises conductorizing the semiconductor layer 114 to form active layer 105.

The conductorizing process can be an ion implantation process or a plasma bombardment process to form the active layer 105. The active layer 105 comprises a channel portion 105a and a first conductor sub-portion 105b and a second conductor sub-portion 105c located on two opposite sides of the channel portion 105a respectively.

In the present embodiment, material, thickness, and structure of the gate electrode insulation layer 109, the first metal layer 104, the active layer 105 have been described detailedly in the aforementioned display panel 100, and no repeated description is here.

With reference to FIG. 4i, when the thin film transistor layer is formed by the step S710 to the step S730, a step S800 comprises:
a step S810 comprising forming a passivation layer 112 and a buffer layer 111.

The step S810 comprises steps as follows:
A step S811 comprises forming a third photoresist material layer on the passivation material layer.
A step S812 comprises by a fourth mask exposing the third photoresist material layer.
A step S813 comprises developing the third photoresist material layer to form a sixth photoresist region and a fourth non-photoresist region.

The fourth non-photoresist region comprises a first photoresist-free sub-region and a second photoresist-free sub-region.

A step S814 comprises by a sixth etching process removing the passivation material layer corresponding to the first photoresist-free sub-region, and removing the passivation material layer and the buffer material layer 115 corresponding to the second photoresist-free sub-region to form the passivation layer 112 and the buffer layer 111.

The sixth etching process can be a dry-etching process.

A step S815 comprises removing the third photoresist material layer.

A step S820 comprises forming a planarization layer 113.

The step S820 comprises steps as follows:
A step S821 comprises by a fifth mask exposing the planarization material layer.
A step S822 comprises developing the planarization material layer to form a first planarization layer 113 via hole and a second planarization layer 113 via hole.

The planarization layer 113 and the passivation layer 112 cooperatively form a first insulation layer, a via hole of the first planarization layer 113, and a first via hole H1 of the first insulation layer formed by removing the passivation material layer corresponding to the first photoresist-free sub-region, the anode 102 is connected to the source electrode 106 or the drain electrode 107 through the first via hole H1. Regarding the second planarization layer 113 via hole, a second via hole of the first insulation layer formed by removing the passivation material layer corresponding to the second photoresist-free sub-region, and a third via hole formed by removing the buffer material layer 115 corresponding to the second photoresist-free sub-region, the third via hole communicates with the second via hole, the anode 102 is connected to a first light shielding portion 110a in the second metal layer 110 through the second via hole and the third via hole.

The passivation material layer corresponding to the first photoresist-free sub-region is removed to expose the source electrode 106 or the drain electrode 107. Also, removal of the passivation material layer corresponding to the first photoresist-free sub-region and removal of the passivation material layer and the buffer material layer 115 corresponding to the second photoresist-free sub-region result in over-etching of the source electrode 106 or the drain electrode 107, damage of a dry-etching process is light to metal material such that the passivation layer 112 and the buffer layer 111 can be formed by the same etching process to lower process costs.

With reference to FIGs. 4j to 4l, in some embodiments, the step S700 comprises:
a S740 comprising forming a semiconductor layer 114 on the buffer layer 111.

In some embodiments, the step S740 steps as follows:
A step S741 comprises forming a semiconductor material layer on the buffer layer 111.
A step S742 comprises fourth-patterning the semiconductor material layer to form the semiconductor layer 114.

The step S742 comprises steps as follows:
A step S742a comprises forming a fourth photoresist material layer on the semiconductor material layer.
A step S742b comprises by a sixth mask exposing the fourth photoresist material layer.
A step S742c comprises developing the fourth photoresist material layer to form a seventh photoresist region and a fifth non-photoresist region.
A step S742d comprises by a seventh etching process removing the semiconductor material layer corresponding to the fifth non-photoresist region to form the semiconductor layer 114.

The seventh etching process can be a wet-etching process.

A step S742e comprises removing the fourth photoresist material layer.

A S750 comprises forming a gate electrode insulation layer 109 and a buffer layer 111.

The step S750 comprises steps as follows:
A step S751 comprises forming a gate electrode insulative material layer on the semiconductor layer 114, wherein the gate electrode insulative material layer covers the semiconductor layer 114 and the buffer material layer 115.
A step S752 comprises fifth-patterning the gate electrode insulative material layer to form the semiconductor layer 114.

The step S752 comprises steps as follows:
A step S752a comprises forming a fifth photoresist material layer on the gate electrode insulative material layer.
A step S752b comprises by a seventh mask exposing the fifth photoresist material layer.
A step S752c comprises developing the fifth photoresist material layer to form an eighth photoresist region and a sixth non-photoresist region.

The sixth non-photoresist region comprises a third photoresist-free sub-region, a fourth photoresist-free sub-region, and a fourth photoresist-free sub-region.

A step S752d comprises by an eighth etching process removing the gate electrode insulative material layer corresponding to the third photoresist-free sub-region and the fourth photoresist-free sub-region and the gate electrode insulative material layer and the buffer material layer 115 corresponding to the fifth photoresist-free sub-region to form the gate electrode insulation layer 109 and the buffer layer 111.

The eighth etching process can be a dry-etching process.

The gate electrode insulation layer 109 comprises a first insulation portion, a second insulation portion, and a third insulation portion. The gate electrode insulative material layer and the buffer layer 111, corresponding to the third photoresist-free sub-region, the fourth photoresist-free sub-region, and the fifth photoresist-free sub-region, are removed, to form a first aperture, a second aperture, and a fourth via hole or a sixth via hole of the gate electrode insulation layer 109, and a fifth via hole or a seventh via hole of the buffer layer 111.

The fourth via hole is located on a side of the second insulation portion away from active layer 105. The buffer layer 111 comprises a fifth via hole, and the fourth via hole communicates with the fifth via hole. The source electrode 106 is connected to the first light shielding portion 110a of the second metal layer 110 through the fourth via hole and the fifth via hole. Alternatively, the sixth via hole is located on a side of the third insulation portion away from the active layer 105, the buffer layer 111 comprises a seventh via hole, the sixth via hole communicates with the seventh via hole, and the drain electrode 107 is connected to the first light shielding portion 110a through the sixth via hole and the seventh via hole.

A step S760 comprises forming an active layer 105 on the semiconductor layer 114.

The active layer 105 is formed by conductorizing the semiconductor layer 114 by utilizing the first aperture and the second aperture.

The conductorizing process can be an ion implantation process or a plasma bombardment process.

A step S770 comprises forming a first metal layer 104 on the gate electrode insulation layer 109.

The first metal layer 104 comprises a source electrode 106, a drain electrode 107, and a gate electrode 108.

The step S770 comprises steps as follows:
A step S771 comprises forming a first metal material layer on the gate electrode insulation layer 109.
A step S772 comprises sixth-processing the first metal material layer to form the first metal layer 104.

The step S772 comprises steps as follows:
A step S772a comprises forming a sixth photoresist material layer on the first metal material layer.
A step S772b comprises by an eighth mask, exposing the sixth photoresist material layer.
A step S772c comprises developing the sixth photoresist material layer to form a ninth photoresist region and a seventh non-photoresist region.

The ninth photoresist region comprises a first photoresist sub-region, a second photoresist sub-region, and a third photoresist sub-region.

A step S772d comprises by a ninth etching process removing the first metal material layer corresponding to the seventh non-photoresist region to form the first metal layer 104.

The first metal material layer corresponding to the first photoresist sub-region, the second photoresist sub-region and the third photoresist sub-region forms the source electrode 106, the drain electrode 107, and the gate electrode 108 respectively.

The ninth etching process can be a wet-etching process.

A step S772e comprises removing the sixth photoresist material layer.

In the present embodiment, material, thicknesses, and structures of the gate electrode insulation layer 109, the first metal layer 104, the active layer 105 have been described detailedly in the aforementioned display panel 100, and no repeated description is here.

With reference to FIG. 4m, when the thin film transistor layer is formed by the step S740 to the step S770, the step S800 comprises:
a step S830 comprising forming a passivation layer 112 and a planarization layer 113 on the thin film transistor layer.

The step S830 comprises steps as follows:
A step S831 comprises forming a passivation material layer on the thin film transistor layer.
A step S832 comprises forming a planarization material layer on the passivation material layer.

Material of the planarization material layer is selected from positive photoresist material or negative photoresist material.

A step S834 comprises seventh-patterning the passivation material layer and the planarization material layer to form the passivation layer 112 and the planarization layer 113.

The step S834 comprises steps as follows:
A step S834a comprises by an eighth mask exposing the planarization material layer.
A step S834b comprises developing the planarization material layer to form a tenth photoresist region and an eighth non-photoresist region to form the planarization layer 113.
A step S834c comprises by a tenth etching process removing the passivation material layer corresponding to the eighth non-photoresist region to form the passivation layer 112.

The tenth etching process can be a dry-etching process.

The planarization layer 113 and the passivation layer 112 cooperatively form a first insulation layer, the eighth non-photoresist region and a first via hole H1 of the first insulation layer is formed by removing the passivation material layer corresponding to the eighth non-photoresist region. The anode 102 is connected to the first metal layer 104 through the first via hole H1.

In the present embodiment, step S500 can comprise steps as follows:
A step S510 comprises forming a second metal material layer on the substrate 101.
A step S520, eighth-patterning the second metal material layer to form the second metal layer 110.

The step S520 comprises steps as follows:
A step S520a comprises forming a seventh photoresist material layer on the second metal material layer.
A step S520b comprises by a tenth mask exposing the seventh photoresist material layer.
A step S520c comprises developing the seventh photoresist material layer to form an eleventh photoresist region and a ninth non-photoresist region.
A step S520d comprises by an eleventh etching process removing the second metal material layer corresponding to the ninth non-photoresist region to form the second metal layer 110.

The eleventh etching process can be a wet-etching process.

A step S520e comprises removing the seventh photoresist material layer.

In the display panel manufacturing method provided by the embodiment of the present invention, manufacturing a film layer between the substrate 101 and the pixel definition portions 103 only requires six patterning processes, which reduces the process costs and improves the process efficiency. Also, the pixel definition portions 103 and the anodes 102 are correspondingly disposed one by one, adjacent ones of the pixel definition portions 103 are spaced, which reduces stress applied to the pixel definition portions 103. Furthermore, the first side surface 103a of the pixel definition portion 103 exhibits a gentler slope, which increases a contact area between the pixel definition portions 103 and an adjacent film layer, enhances firmness of bonding between the pixel definition portion 103 and an adjacent film layer, and improves product quality of manufacture of the display panel.

The embodiment of the present invention discloses a display panel and a manufacturing method thereof. The display panel comprises a substrate, a plurality of anodes located on the substrate, a plurality of pixel definition portions covering edges of the anodes and partially exposing the anodes. Each of the pixel definition portions surrounds one of the anodes. Adjacent ones of the pixel definition portions are disposed at intervals. Along a direction parallel to the substrate, the pixel definition portion comprises a first side surface away from anode. A first included angle is defined between a side of the first side surface near the substrate and the substrate. The first included angle ranges from 35 degrees to 45 degrees. The present invention enhances the product quality of the display panel by implementing a configuration where pixel definition portions are individually matched with anodes, with a spacing between adjacent pixel definition portions. This arrangement effectively reduces the stress experienced by the pixel definition portions. Furthermore, the first side surface of the pixel definition portions exhibits a gentler slope, resulting in an increased contact area between the pixel definition portions and an adjacent film layer. This strengthens the bond between the pixel definition portions and the adjacent film layer, thereby improving the overall product quality of the display panel.

It can be understood that for a person of ordinary skill in the art, equivalent replacements or changes can be made according to the technical solution of the present application and its inventive concept, and all these changes or replacements should belong to the scope of protection of the appended claims of the present application.

## Claims

1. A display panel, comprising:
a substrate;
a plurality of anodes disposed on the substrate; and
a plurality of pixel definition portions covering edges of the anodes and exposing the anodes partially;
wherein each of the pixel definition portions surrounds one of the anodes, and adjacent ones of the pixel definition portions are disposed at intervals;
wherein along a direction parallel to the substrate, the pixel definition portion comprises a first side surface away from the anodes, a first included angle is defined between a side of the first side surface near the substrate and the substrate, the first included angle ranges from 35 degrees to 45 degrees.

2. The display panel according to claim 1, further comprising a first metal layer located between the anodes and the substrate; and
a first insulation layer located between the first metal layer and the anodes and comprising a first via hole, wherein the anode comprises a first connection portion located in the first via hole and connected to the first metal layer, and the pixel definition portion covers the first connection portion.

3. The display panel according to claim 2, further comprising an active layer located between the first metal layer and the substrate and comprising a channel portion , a first conductor sub-portion and a second conductor sub-portion that are located on two opposite sides of the channel portion respectively; wherein
the first metal layer comprises a source electrode and a drain electrode, the source electrode is located on the first conductor sub-portion, the drain electrode is located on the second conductor sub-portion; and
a side of at least a part of the source electrode near the active layer contacts the first conductor sub-portion, and a side of at least a part of the drain electrode near the active layer contacts the second conductor sub-portion.

4. The display panel according to claim 3, wherein further comprising a gate electrode located between the source electrode and the drain electrode, wherein an orthographic projection of the gate electrode on the active layer covers the channel portion; and
a gate electrode insulation layer at least located between the gate electrode and the channel portion.

5. The display panel according to claim 4, wherein the gate electrode is located on the first metal layer, the gate electrode insulation layer comprises a first insulation portion, a second insulation portion, and a third insulation portion disposed separately from one another, the first insulation portion is disposed between the channel portion and the gate electrode, the second insulation portion is disposed between a part of the source electrode and the first conductor sub-portion, the third insulation portion is disposed between a part of the drain electrode and the second conductor sub-portion; and
an end of the source electrode near the gate electrode contacts the first conductor sub-portion, an end of the drain electrode near the gate electrode contacts the second conductor sub-portion.

6. The display panel according to claim 4, wherein the gate electrode is located on a side of the first metal layer away from the substrate, no insulation layer is disposed between the source electrode and the first conductor sub-portion, and no insulation layer is disposed between the drain electrode and the second conductor sub-portion.

7. The display panel according to claim 6, wherein in a plane parallel to the substrate, along a direction from the channel portion to the first conductor sub-portion, an edge of a side of the source electrode away from the gate electrode extends beyond an edge of a side of the first conductor sub-portion away from the channel portion; and
in the plane parallel to the substrate, along a direction from the channel portion to the second conductor sub-portion, an edge of a side of the drain electrode away from the gate electrode extends beyond an edge of a side of the second conductor sub-portion away from the channel portion.

8. The display panel according to claim 3, further comprising a second metal layer located between the active layer and the substrate and comprising a first light shielding portion, wherein an orthographic projection of the active layer on the substrate is located within an orthographic projection of the first light shielding portion on the substrate; and
a buffer layer located on a side of the active layer near the substrate and covering the second metal layer.

9. The display panel according to claim 8, wherein the first insulation layer comprises a passivation layer located near the substrate, the buffer layer is located between the second metal layer and the active layer, a side of the buffer layer away from the substrate directly contacts the active layer and the passivation layer; and
a side of the buffer layer near the substrate directly contacts the second metal layer and the substrate.

10. The display panel according to claim 9, wherein when the gate electrode insulation layer comprises a first insulation portion, a second insulation portion, and a third insulation portion that are disposed separately from one another, an end of the second insulation portion away from the first insulation portion contacts the buffer layer, and an end of the third insulation portion away from the first insulation portion contacts the buffer layer.

11. The display panel according to claim 8, wherein the first insulation layer further comprises a second via hole located on a side of the active layer;
the buffer layer comprises a third via hole communicating with the second via hole, the anode is connected to the first light shielding portion through the second via hole and the third via hole; and
the anode comprises a second connection portion, and an orthographic projection of the pixel definition portions on the substrate covers an orthographic projection of the second connection portion on the substrate.

12. The display panel according to claim 8, wherein a gate electrode insulation layer comprises a fourth via hole located in a side of a second insulation portion away from active layer, the buffer layer comprises a fifth via hole communicating with the fourth via hole, and the source electrode is connected to the first light shielding portion through the fourth via hole and the fifth via hole.

13. The display panel according to claim 8, wherein a gate electrode insulation layer comprises a sixth via hole located on a side of a third insulation portion away from the active layer, the buffer layer comprises a seventh via hole, the sixth via hole communicates with the seventh via hole, and the drain electrode is connected to the first light shielding portion through the sixth via hole and the seventh via hole.

14. The display panel according to claim 2, wherein the display panel comprises a display region and a non-display region located on at least one side of the display region, the display panel further comprises a terminal located in the non-display region, and the terminal is located on the first metal layer; and
the terminal comprises a first terminal, and the first terminal is connected to the second metal layer.

15. The display panel according to claim 14, wherein when a gate electrode insulation layer comprises a first insulation portion, a second insulation portion, and a third insulation portion that are disposed separately from one another, the gate electrode insulation layer further comprises a fourth insulation portion located between the terminal and a buffer layer, the gate electrode insulation layer comprises an eighth via hole defined through the fourth insulation portion, the buffer layer comprises a ninth via hole defined through the buffer layer between the second metal layer wiring and the fourth insulation portion, an orthographic projection of the eighth via hole on the substrate covers an orthographic projection of the ninth via hole on the substrate; and
the first terminal comprises a first terminal connection portion located in the eighth via hole and the ninth via hole, the eighth via hole and the ninth via hole expose the second metal layer wiring, and the first terminal connection portion contacts the second metal layer wiring.

16. The display panel according to any one of claims 1 to 15, wherein the pixel definition portions and the anodes include an overlapping portion, and a width of an orthographic projection of the overlapping portion on the substrate is greater than 2 microns.

17. The display panel according to claim 16, wherein the display panel further comprises an organic layer located on a side of the anodes away from the substrate and comprising a light emitting layer; and
along the direction parallel to the substrate, the pixel definition portion comprises a second side surface near the anode, an orthographic projection of the anode on the substrate and an orthographic projection of the second side surface on the substrate commonly cover an orthographic projection of the light emitting layer on the substrate.

18. The display panel according to claim 17, wherein a side of the second side surface near the anode and the anode comprises a second included angle, and the second included angle ranges from 35 degrees to 45 degrees.

19. A display panel manufacturing method, comprising:
providing a substrate;
forming an anode material layer on the substrate;
forming a pixel definition material layer on the anode material layer; and
first-patterning the anode material layer and the pixel definition material layer to form a plurality of anodes and a plurality of pixel definition portions, respectively;
wherein the pixel definition portions cover edges of the anodes expose the anodes partially, each of the pixel definition portions surrounds one of the anodes, and adjacent ones of the pixel definition portions are disposed at intervals;
wherein along a direction parallel to the substrate, the pixel definition portion comprises a first side surface away from the anodes, a first included angle is defined between a side of the first side surface near the substrate and the substrate, the first included angle ranges from 35 degrees to 45 degrees.

20. The display panel manufacturing method according to claim 19, wherein before the step of forming the anode material layer on the substrate, the method further comprises:
forming a semiconductor material layer on the substrate;
forming a first metal material layer on the semiconductor material layer, wherein the first metal material layer directly contacts the semiconductor material layer; and
second-processing the semiconductor material layer and the first metal material layer to form a semiconductor layer and a first metal layer respectively;
wherein the first metal layer comprises a source electrode and a drain electrode, wherein the source electrode and the drain electrode are located on two opposite sides of the semiconductor layer.
